# EUROPÄISCHE PATENTSCHRIFT

(11) **EP 2 681 835 B1**
(45) Veröffentlichungstag und Bekanntmachung des Hinweises auf die Patenterteilung: **29.07.2020**
(21) Anmeldenummer: 12715537.2
(22) Anmeldetag: 19.03.2012
(51) Int. Cl.: H02M 7/00, H05K 7/20, H02M 7/483

(54) **ZWEITEILIGE STROMRICHTERZELLE**
BIPARTITE CONVERTER CELL
CELLULE DE CONVERTISSEUR DE PUISSANCE EN DEUX PARTIES

(30) Priorität: 07.04.2011 DE 102011006988
(43) Veröffentlichungstag der Anmeldung: 08.01.2014
(73) Patentinhaber: Siemens Aktiengesellschaft, 80333 München (DE)
(72) Erfinder: HILLER, Marc, 91207 Lauf an der Pegnitz (DE); PFAUSER, Anton, 96178 Pommersfelden (DE)
(86) Internationale Anmeldenummer: PCT/EP2012/054795
(87) Internationale Veröffentlichungsnummer: WO 2012/136467

(56) Entgegenhaltungen:
- EP-A2- 2 006 987
- WO-A1-94/14227
- WO-A1-2008/074274
- JP-A- 2005 347 561
- US-A1- 2010 321 889

## Beschreibung

Die Erfindung bezieht sich auf eine zweiteilige Stromrichterzelle eines modularen Multilevel-Stromrichters.

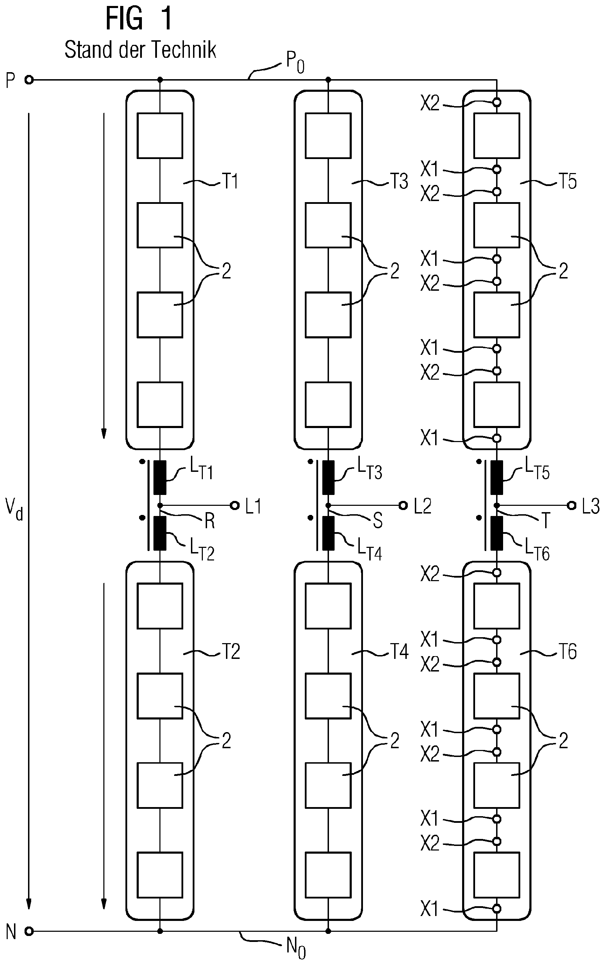

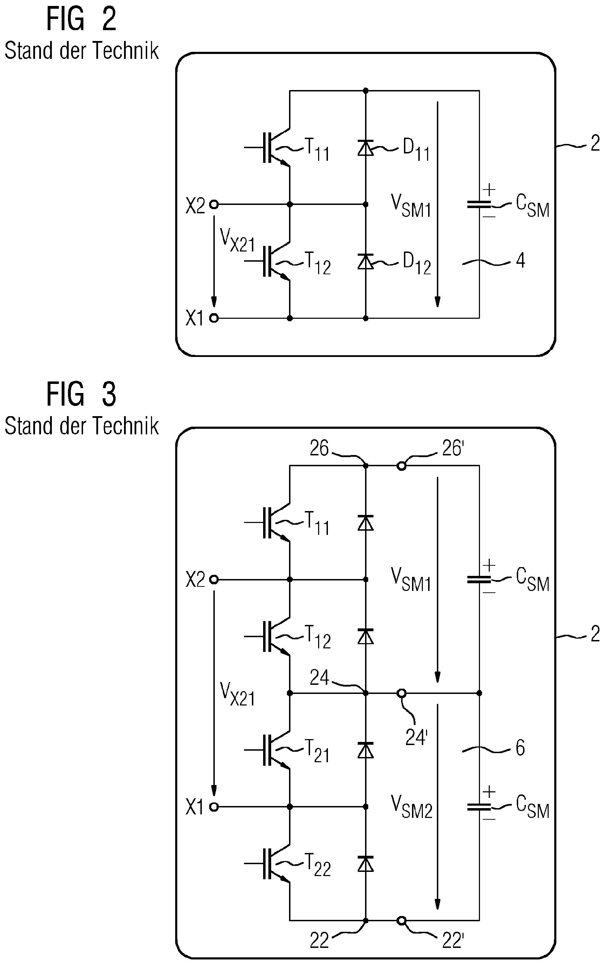

Aus der DE 101 03 031 A1 ist ein modularer Multilevel-Stromrichter bekannt, der auch als Modular Multilevel-Converter (M2LC) bezeichnet wird. Ein Ersatzschaltbild eines derartigen dreiphasigen Stromrichters ist in FIG 1 näher dargestellt. Gemäß diesem Ersatzschaltbild weist dieser modulare Multilevel-Stromrichter drei Phasenmodule R, S und T auf, die jeweils ein oberes und ein unteres Stromrichterventil T1, T2 bzw. T3, T4 bzw. T5, T6 und zwei Zweigdrosseln L_{T1}, L_{T2} bzw. L_{T3}, L_{T4} bzw. L_{T5}, L_{T6} aufweisen. Jedes Stromrichterventil T1,...,T6 dieser Phasenmodule R, S und T weist wenigstens zwei Stromrichterzellen 2 auf, die elektrisch in Reihe geschaltet sind. Im dargestellten Ersatzschaltbild weist jedes Stromrichterventil T1,...,T6 vier Stromrichterzellen 2 auf. Das Ersatzschaltbild einer Stromrichterzelle 2 dieses modularen Multilevel-Stromrichters ist in FIG 2 näher dargestellt. Jede Zweigdrossel L_{T1},...,L_{T6} ist mit einer Reihenschaltung mehrerer Stromrichterzellen 2 eines Stromrichterventils T1,...,T6 elektrisch in Reihe geschaltet. Jeweils ein Verbindungspunkt zweier Zweigdrosseln L_{T1}, L_{T2} bzw. L_{T3}, L_{T4} bzw. L_{T5}, L_{T6} eines Phasenmoduls R bzw. S bzw. T bilden einen Ausgangs-Anschluss L1 bzw. L2 bzw. L3 des modularen Multilevel-Stromrichters. An diesen Ausgangs-Anschlüssen L1, L2 und L3 steht im Betrieb jeweils eine sinusförmige, stufenförmige Stromrichter-Ausgangsspannung an. Jede Stromrichterzelle 2 eines Stromrichterventils T1, T2 bzw. T3, T4 bzw. T5, T6 bildet eine Spannungsstufe dieser stufenförmigen Ausgangsspannung. Je mehr Stromrichterzellen 2 innerhalb eines Stromrichterventils T1, T2 bzw. T3, T4 bzw. T5, T6 verwendet werden, umso feinstufiger ist die sinusförmige Ausgangsspannung jeweils an den Ausgangs-Anschlüssen L1,L2 bzw. L3 des modularen Multilevel-Stromrichters. Je feinstufiger diese sinusförmige Ausgangsspannung ist, desto geringer wird der Aufwand für ein Ausgangsfilter.

Der elektrische Aufbau einer Stromrichterzelle 2 des modularen Multilevel-Stromrichters, dessen Ersatzschaltbild in FIG 2 näher dargestellt ist, ist ebenfalls aus der DE 10 103 031 A1 bekannt. Als Stromrichterzelle 2 ist ein so genanntes zweipoliges Subsystem 4 vorgesehen, das zwei abschaltbare Halbleiter T₁₁ und T₁₂, insbesondere **I**nsulated-**G**ate-Bipolar-**T**ransistors (IGBT), zwei Freilauf-Dioden D₁₁ und D₁₂ und einen Speicherkondensator C_{SM} aufweist. Die beiden abschaltbaren Halbleiter T₁₁ und T₁₂ sind elektrisch in Reihe geschaltet. Dieser Reihenschaltung ist der Speicherkondensator C_{SM} elektrisch parallel geschaltet. Jede Freilauf-Diode D11 und D₁₂ ist einem abschaltbaren Halbleiter T₁₁ und T₁₂ elektrisch antiparallel geschaltet. Ein Anschluss X2 dieser Stromrichterzelle 2 wird vom Verbindungspunkt der beiden abschaltbaren Halbleiter T₁₁ und T₁₂ des zweipoligen Subsystems 4 gebildet. Ein weiterer Anschluss X1 dieser Stromrichterzelle 2 wird vom negativen Pol des Speicherkondensators C_{SM}, der mit einem Anoden-Anschluss der Freilauf-Diode D₁₂ und einem Emitter-Anschluss des abschaltbaren Halbleiters T₁₂ elektrisch leitend verbunden ist, gebildet. An diesen Anschlüssen X2 und X1 der Stromrichterzelle 2 steht eine Zellenspannung V_{X21} an. Am Speicherkondensator C_{SM}, insbesondere einem Elektrolytkondensator, steht eine Kondensator-Spannung V_{SM} an, wenn dieser aufgeladen ist. Die Amplitude der Zellenspannung V_{X21} der Stromrichterzelle kann abhängig vom Schaltzustand der abschaltbaren Halbleiter T₁₁ und T₁₂ gleich der Amplitude der Kondensator-Spannung V_{SM} sein oder 0V betragen. Für weitere Einzelheiten zum bekannten modularen Multilevel-Stromrichter, insbesondere der Steuerung der Stromrichterzelle 2, wird auf die genannte DE 10 103 031 A1 verwiesen.

In FIG 3 ist ein Ersatzschaltbild eines so genannten Doppel-Submoduls 6 dargestellt, das ebenfalls als Stromrichterzelle 2 eines modularen Multilevel-Stromrichters verwendet werden kann. Ein derartiges Doppel-Submodul 6 ist aus der DE 10 2005 041 087 A1 bekannt. Dieses Doppel-Submodul 6 weist gemäß dem Ersatzschaltbild vier abschaltbare Halbleiter T₁₁, T₁₂, T₂₁ und T₂₂, insbesondere IGBTs, vier Freilauf-Dioden D₁₁, D₁₂, D₂₁ und D₂₂ und zwei Speicherkondensatoren C_{SM} auf. Eine in der DE 10 2005 041 087 A1 gezeigte Elektronik-Baugruppe des Doppel-Submoduls 6 ist hier nicht explizit dargestellt. Diese vier abschaltbaren Halbleiter T₁₁, T₁₂, T₂₁ und T₂₂ sind elektrisch in Reihe geschaltet. Jedem dieser abschaltbaren Halbleiter T₁₁, T₁₂, T₂₁ und T₂₂ ist eine Freilauf-Diode D₁₁, D₁₂, D₂₁ und D₂₂ elektrisch parallel geschaltet. Das heißt, jede Diode ist antiparallel zum korrespondierenden abschaltbaren Halbleiter geschaltet. Jeweils ein Speicherkondensator C_{SM} ist elektrisch parallel zu jeweils zwei elektrisch in Reihe geschalteten abschaltbaren Halbleiter T₁₁, T₁₂ und T₂₁, T₂₂ geschaltet. Diese beiden Speicherkondensatoren C_{SM}, insbesondere Elektrolytkondensatoren, sind außerdem elektrisch in Reihe geschaltet. Der Anschluss X2 der Stromrichterzelle 2 wird bei diesem Doppel-Submodul 6 vom Verbindungspunkt der beiden abschaltbaren Halbleiter T₁₁ und T₁₂ gebildet, wogegen der Anschluss X1 dieser Stromrichterzelle 2 vom Verbindungspunkt der beiden abschaltbaren Halbleiter T₂₁ und T₂₂ gebildet wird. An diesen beiden Anschlüssen X2 und X1 der Stromrichterzelle 2 steht eine Zellenspannung V_{X21} an, die gegenüber der Ausführungsform der Stromrichterzelle 2 gemäß FIG 2 vier Potentialstufen aufweist. Dadurch kann die gleiche Stufenzahl wie mit Stromrichterzellen 2 gemäß FIG 2 erzeugt werden, aber mit halb so vielen Stromrichterzellen 2. Für weitere Einzelheiten, insbesondere der Steuerung dieses Doppel-Submoduls 6, wird auf die DE 10 2005 041 087 A1 verwiesen.

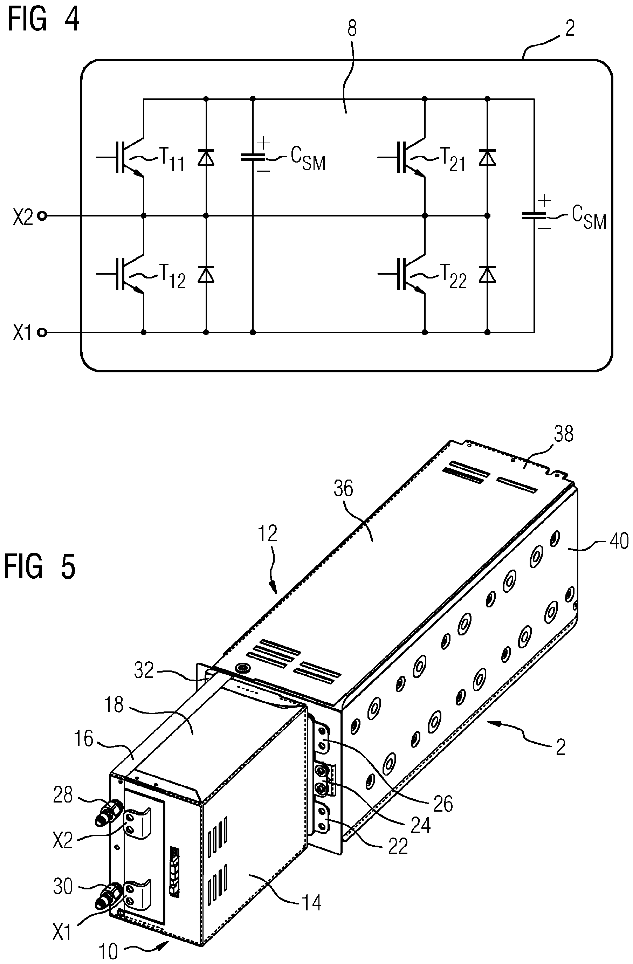

In FIG 4 ist ein Ersatzschaltbild einer weiteren Ausführungsform einer Stromrichterzelle 2 schematisch dargestellt. Bei dieser Ausführungsform handelt es sich um ein so genanntes Single-Submodul 8, das gegenüber der Ausführungsform gemäß FIG 2 einen doppelten Zellenstrom führen kann. Die Bauelemente dieses Single-Submoduls 8 entsprechen den Bauelementen des Doppel-Submoduls 6 der FIG 3. Die Bauelemente sind jedoch anders miteinander verschaltet. Diese beiden Reihenschaltungen der beiden abschaltbaren Halbleiter T₁₁, T₁₂ und T₂₁, T₂₂ sind jeweils mit elektrisch parallel geschalteten Speicherkondensatoren C_{SM} elektrisch parallel geschaltet. Die Anschlüsse X2 und X1 der Stromrichterzelle 2 entsprechen den Anschlüssen X2 und X1 der Stromrichterzelle 2 der FIG 2.

Aus der EP 1 920 528 B1 ist ein weiterer modularer Multilevel-Stromrichter bekannt. Dieser weitere modulare Multilevel-Stromrichter weist als Stromrichterzellen jeweils einen Spannungszwischenkreis-Umrichter auf, der speiseseitig entweder eine sechspulsige Diodenbrücke oder eine sechspulsige IGBT-Brücke aufweist. Lastseitig weist diese Stromrichterzelle einen einphasigen selbstgeführten Pulsstromrichter auf. Diese beiden Stromrichter eines Spannungszwischenkreis-Umrichters sind gleichspannungsseitig mittels eines Speicherkondensators elektrisch leitend miteinander verbunden. Die wechselspannungsseitigen Anschlüsse der sechspulsigen Diodenbrücke der Stromrichter sind mit einem dreiphasigen Sekundärwicklungssystem eines Stromrichter-Transformators verknüpft. Die wechselspannungsseitigen Ausgänge des einphasigen selbstgeführten Pulsstromrichters der Stromrichterzelle sind mit weiteren Stromrichterzellen einer Phase elektrisch in Reihe geschaltet.

Ein in dem EP-Patent beschriebener Multilevel-Stromrichter weist pro Phase vier Stromrichterzellen auf, die jeweils speiseseitig mit einem dreiphasigen Sekundärwicklungssystem eines Stromrichter-Transformators verknüpft sind. Dadurch wird ein Stromrichter-Transformator benötigt, der zwölf dreiphasige Sekundärwicklungssysteme aufweist. Die Phasen des modularen Multilevel-Stromrichters sind in Stern verschaltet, wobei an den freien Enden dieser Phasen (Stromrichter-Ausgänge) ein Drehstrommotor anschließbar ist. Durch die Verwendung von abschaltbaren Halbleitern anstelle von Dioden speiseseitig kann Energie wieder in ein speisendes Netz zurückgespeist werden. Außerdem kann dieser speiseseitige selbstgeführte Stromrichter, der auch als **A**ctive-**F**ront-**E**nd (AFE) bezeichnet wird, so gesteuert werden, dass der Leistungsfaktor cosϕ=1 und dass die Gleichspannung am Speicherkondensator einem vorbestimmten Sollwert entspricht. Nachteilig wirken sich der hohe Platzbedarf und das erhöhte Gewicht der Stromrichterzelle aus.

Gemäß FIG 5 dieses EP-Patents sind alle Bauelemente in einem Gehäuse der Stromrichterzelle untergebracht. Da die speise- und lastseitigen abschaltbaren Halbleiter einer Stromrichterzelle Verluste generieren, sind diese zumindest mit einem Kühlkörper thermisch gekoppelt. Als Kühlkörper wird entweder ein Luft-Kühlkörper oder ein Flüssigkeits-Kühlkörper verwendet.

Aus der Patentliteratur US2010/321889 A1, EP2006987 A2, JP2005347561 A und WO2008/074274 A1 ist ein zweiteiliger Stromrichter bekannt, bei dem eine Halbleitereinheit und eine Kondensatoreinheit trennbar voneinander ausgeführt sind. Insbesondere WO2008/074274 A1 offenbart eine zweiteilige Stromrichterzelle eines modularen Multilevel-Stromrichters umfassend eine Halbleiter-Baueinheit und eine Kondensator-Baueinheit, die in einem Traggerüst des modularen Multilevel-Stromrichters verknüpfbar sind.

Wegen des Gewichts einer derartigen Stromrichterzelle wird bei der Montage bzw. Demontage dieser Stromrichterzelle in bzw. aus einem Traggerüst ein Hilfsmittel, beispielsweise eine Hebevorrichtung benötigt, die so konstruiert ist, dass einerseits die Stromrichterzelle auf jeder Einbauhöhe gehalten werden kann und andererseits diese von dieser Einbauhöhe in eine Aufnahmeeinheit des Traggerüsts geschoben werden kann. Das heißt, dass beim Austausch einer fehlerhaften Stromrichterzelle dieses Hilfsmittel vorhanden sein muss. Ist ein derartiger modularer Multilevel-Stromrichter an einem schlecht zugänglichen Einbauort unterzubringen, kann die Verwendung eines derartigen Hilfsmittels die Montage bzw. Demontage von Stromrichterzellen erheblich erschweren.

Der Erfindung liegt nun die Aufgabe zugrunde, die Stromrichterzelle eines bekannten Multilevel-Stromrichters derart zu gestalten, dass sich der Aufwand für Montage bzw. Demontage einer Stromrichterzelle derart wesentlich vereinfacht, dass keine Hilfsmittel mehr benötigt werden.

Diese Aufgabe wird erfindungsgemäß gelöst mit den Merkmalen des Anspruchs 1.

Dadurch, dass die Stromrichterzelle zweiteilig ausgeführt wird, nämlich in eine Halbleiter-Baueinheit und eine Kondensator-Baueinheit, sind die Gewichte der einzelnen Baueinheiten derart reduziert, dass bei der Montage bzw. Demontage dieser Baueinheiten nacheinander keine Hilfsmittel mehr benötigt werden. Ein weiterer Vorteil besteht darin, dass jede Baueinheit für sich geprüft werden kann. Außerdem kann jede Baueinheit für sich an neue Leistungen einer Stromrichterzelle preiswert angepasst werden.

Da die abschaltbaren Halbleiter und die zugehörigen Freilauf-Dioden gemeinsam auf einem Kühlkörper angeordnet sind, können diese Halbleiter-Bauelemente mittels eines Verschienungssystems niederinduktiv miteinander elektrisch leitend verschaltet werden. Als Tragplatte der Halbleiter-Baueinheit dient der Kühlkörper, der zusammen mit einer Haube das Gehäuse dieser Halbleiter-Baueinheit bildet. Da der Kühlkörper einen Teil des Gehäuses der Halbleiter-Baueinheit bildet, auf dem alle Bauelemente dieser Halbleiter-Baueinheit aufgebaut sind, kann bei dieser Halbleiter-Baueinheit diese Halbleiter-Baueinheit sehr einfach als luft- oder flüssigkeitsgekühlte Baueinheit ausgeführt werden. Dazu muss nur ein Kühlkörper in entsprechender Ausbildung gewählt werden. Außerdem kann durch diese Ausgestaltung der Halbleiter-Baueinheit diese sehr kompakt ausfallen.

Um die Verschaltung einer Vielzahl von Stromrichterzellen eines modularen Multilevel-Stromrichters zu vereinfachen, sind die Anschlüsse einer jeden Stromrichterzelle frontseitig an der Halbleiter-Baueinheit angeordnet. Wird ein Flüssigkeits-Kühlkörper zur Entwärmung der verwendeten Halbleiter-Bauelemente verwendet, ist es für eine besonders einfache Montage notwendig, befinden sich Anschlüsse für Zu- und Ablauf einer Flüssigkeit ebenfalls an der Frontseite der Halbleiter-Baueinheit, so dass ebenfalls die Montage des Flüssigkeitskreislaufes besonders einfach ausfällt. Dies macht sich besonders dann bemerkbar, wenn eine fehlerhafte Stromrichterzelle aus einem montierten betriebsfertigen modularen Multilevel-Stromrichters getauscht werden muss.

In der Kondensator-Baueinheit sind alle Kondensatoren, insbesondere Elektrolytkondensatoren, eines Speicherkondensators der Stromrichterzelle untergebracht. Dazu sind diese in wenigstens zwei Reihen versetzt zueinander angeordnet. Die Verschaltung dieser Kondensatoren erfolgt mittels eines Verschienungssystems. So werden die Kondensatoren elektrisch parallel und/oder in Reihe geschaltet. Dadurch kann man mit handelsüblichen Kondensatoren, insbesondere Elektrolytkondensatoren, jeden beliebigen Kapazitätswert eines Speicherkondensators aufbauen.

Für eine einfache Fertigung dieser Kondensatoreinheit besteht das Gehäuse dieser Kondensatoreinheit aus einem U-förmigen Blech und dem Verschienungssystem. Letzteres bildet eine Wand des Gehäuses. Wegen der Entwärmung der Kondensatoren ist das Gehäuse stirnseitig offen. Diese Kondensatoren der Kondensator-Baueinheit sind mit einem Grundblech des U-förmigen Blechs mechanisch lösbar befestigt. Dadurch werden die elektrischen Anschlüsse eines jeden Kondensators von mechanischen Kräften entlastet. Nachdem die Kondensatoren mit dem Verschienungssystem elektrisch leitend verbunden sind, ist jeder Kondensator beidseitig mechanisch in seiner Lage innerhalb des Gehäuses der Kondensator-Baueinheit fixiert, damit gegen Erschütterungen gesichert.

Damit die Halbleiter-Baueinheit und die Kondensator-Baueinheit einfach miteinander elektrisch leitend verbunden werden können, ragen die Anschlüsse des Verschienungssystems der Kondensator-Baueinheit in die frontseitige Stirnseite seines Gehäuses, wobei die Anschlüsse des Verschienungssystems der Halbleiter-Baueinheit rückseitig seitwärts aus dem Gehäuse herausragen. Dabei sind die Halbleiter-Baueinheit und die Kondensator-Baueinheit derart zueinander angeordnet, dass die Anschlüsse dieser beiden Baueinheiten fluchtend zueinander sind. Diese Anforderung kann nur dann erfüllt werden, wenn die Halbleiter-Baueinheit schmaler ausfällt als die Kondensator-Baueinheit. Die Zentrierung der Anschlüsse der Kondensator-Baueinheit werden mit Hilfe einer Zentrierplatte zentriert.

Durch die zweiteilige Ausbildung der Stromrichterzelle eines modularen Multilevel-Stromrichters wird erreicht, dass jede Baueinheit für sich optimiert werden kann, dass sich das Gewicht einer Stromrichterzelle auf zwei Baueinheiten derart aufteilt, dass jede Baueinheit für sich gewichtsmäßig ohne Hilfsmittel händelbar ist und dass die Halbleiter-Baueinheit ohne großen Aufwand von einer auf Flüssigkeitskühlung auf eine Luftkühlung umgerüstet werden kann. Außerdem sinken die Fertigungskosten des erfindungsgemäßen Stromrichters, da mit einem Minimum an Einzelteilen ein einfacher mechanischer Aufbau realisiert werden kann.

Zur weiteren Erläuterung der Erfindung wird auf die Zeichnung Bezug genommen, in der eine Ausführungsform der zweiteiligen Stromrichterzelle nach der Erfindung schematisch veranschaulicht ist.
- FIG 1: zeigt ein Ersatzschaltbild eines bekannten dreiphasigen modularen Multilevel-Stromrichters, in der
- FIG 2: ist ein Ersatzschaltbild einer Stromrichterzelle in der Ausführungsform Single-Submodul dargestellt, die
- FIG 3: zeigt ein Ersatzschaltbild einer Stromrichterzelle in der Ausführungsform Doppel-Submodul, wobei die
- FIG 4: ein Ersatzschaltbild einer Stromrichterzelle in der Ausführungsform Single-Submodul mit höherer Stromtragfähigkeit zeigt, in der
- FIG 5: ist eine zweiteilige Stromrichterzelle nach der Erfindung perspektivisch dargestellt, die
- FIG 6: zeigt eine Halbleiter-Baueinheit der zweiteiligen Stromrichterzelle gemäß FIG 5 in einer Explosionsdarstellung, wogegen in der
- FIG 7: die Kondensator-Baueinheit der zweiteiligen Stromrichterzelle nach FIG 5 im geöffneten Zustand perspektivisch dargestellt ist.

Eine zweiteilige Stromrichterzelle 2 nach der Erfindung ist in FIG 5 perspektivisch dargestellt. Diese zweiteilige Stromrichterzelle 2 weist erfindungsgemäß eine Halbleiter-Baueinheit 10 und eine Kondensator-Baueinheit 12 auf. Das Gehäuse 14 der Halbleiter-Baueinheit 10 umfasst einen Kühlkörper 16, eine Haube 18 und einen Teil eines Verschienungssystems 20, der mit mehreren Anschlüssen 22, 24 und 26 versehen ist. Frontseitig sind die Anschlüsse X2 und X1 der Stromrichterzelle 2 angeordnet. Da der Kühlkörper 16 als Flüssigkeitskühlkörper ausgebildet ist, sind ein Zu- und Ablauf-Anschluss 28 und 30 für eine Kühlflüssigkeit ebenfalls frontseitig angeordnet. Zur mechanischen Befestigung der Halbleiter-Baueinheit 10 und zur elektrischen Kontaktierung weist der Kühlkörper 16 einen Befestigungsflansch 32 auf, der rückwärtig entlang der Höhe des Kühlkörpers 16 angeordnet ist.

Die Kondensator-Baueinheit 12 weist eine Vielzahl von Kondensatoren 34, insbesondere Folienkondensatoren, auf, die in dieser Darstellung nicht sichtbar sind, da das Gehäuse 36 dieser Kondensator-Baueinheit 12 geschlossen ist. Das stirnseitig offene Gehäuse 36 wird gebildet von einem U-förmigen Blech 38 und einem Verschienungssystem 40. Mit diesem Verschienungssystem 40 wird die Vielzahl von Folienkondensatoren 34 elektrisch parallel und/oder in Reihe geschaltet.

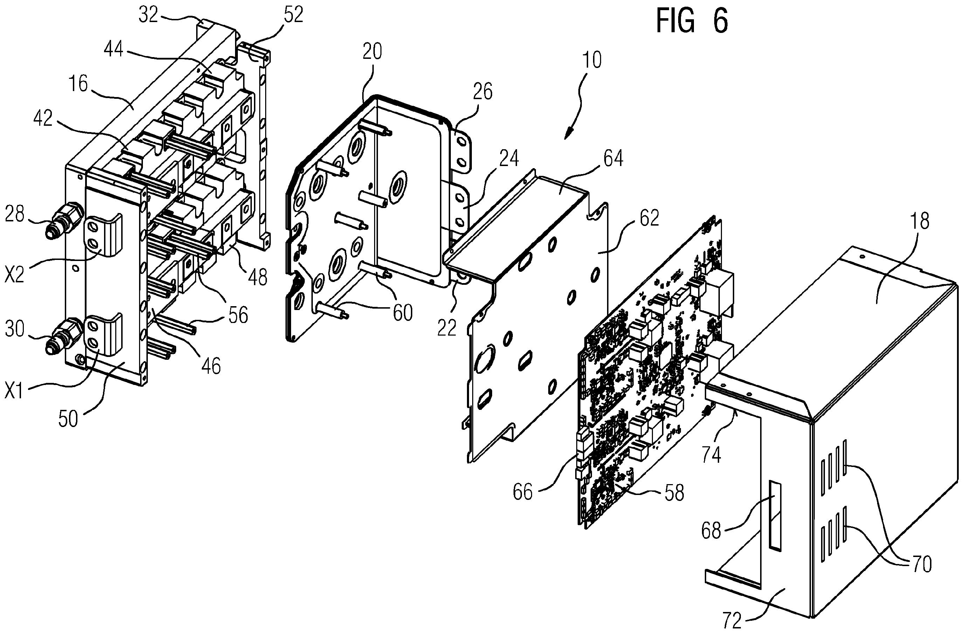

Die Halbleiter-Baueinheit 10 der zweiteiligen Stromrichterzelle 2 nach FIG 5 ist in FIG 6 perspektivisch als Explosionsdarstellung dargestellt. Gemäß dieser Darstellung weist die Halbleiter-Baueinheit 10 den Kühlkörper 16 mit den zu kühlenden Halbleitermodulen 42, 44, 46 und 48 auf, die jeweils einen abschaltbaren Halbleiter T₁₁, T₁₂, T₂₁ oder T₂₂, insbesondere einen IGBT mit zugehöriger Freilauf-Diode D₁₁, D₁₂, D₂₁ oder D₂₂, enthalten. An Stelle von vier Halbleitermodulen pro Halbleiter-Baueinheit 10 können auch nur zwei Halbleitermodule T₁₁, T₁₂ und T₂₁, T₂₂ jeweils in einer Halbleiter-Baueinheit 10 untergebracht sind. Stirnseitig weist der bestückte Kühlkörper 16, der als Tragplatte für diese Baueinheit 10 dient, eine Wand 50 auf, aus der die beiden Anschlüsse X2 und X1 der Stromrichterzelle 2 herausragen. Rückseitig ist eine Stützwand 52 angeordnet. Da es sich beim Kühlkörper 16 um einen Flüssigkeitskühlkörper handelt, sind dessen Anschlüsse für Zu- und Ablauf 28 und 30 einer Kühlflüssigkeit, insbesondere entionisiertes Wasser, frontseitig der Halbleiter-Baueinheit 10 angeordnet.

Zur mechanischen Befestigung dieser Halbleiter-Baueinheit 10 mit der Kondensator-Baueinheit 12 zu einer Stromrichterzelle 2 weist der Kühlkörper 16 einen Befestigungsflansch 32 auf, der rückseitig auf der den Halbleitermodulen 42, 44, 46 und 48 abgewandten Seite des Kühlkörpers 16 angebracht ist. Auf diesen Halbleitermodulen 42, 44, 46, 48 ist ein Verschienungssystem 20 angeordnet, mit dem diese Halbleitermodule 42, 44, 46 und 48 gemäß dem Ersatzschaltbild der FIG 3 verschaltet werden. Gemäß diesem Ersatzschaltbild weist die Reihenschaltung der vier abschaltbaren Halbleiter T₁₁, T₁₂, T₂₁ und T₂₂ drei Anschlüsse 22, 24 und 26 auf. Der Anschluss 22 weist ein negatives Potential N, der Anschluss 24 das Bezugspotential Null und der Anschluss 26 ein positives Potential P einer durch die Kondensator-Baueinheit 12 realisierten Speichereinheit auf. Die Verschaltung der Halbleitermodule 42, 44, 46, 48 auf dem Kühlkörper 16 mit entsprechenden Stromschienen des Verschienungssystems 20, das L-förmig ausgebildet ist, erfolgt mittels Bolzen 56.

Oberhalb dieses Verschienungssystems 20, das ebenfalls zur Kontaktierung einer Elektronik-Baugruppe 58 Bolzen 60 aufweist, ist ein Schirmblech 62 vorgesehen. Dieses Schirmblech 62 weist entlang einer Schmalseite der Halbleiter-Baueinheit 10 eine Stützfläche 64 auf, mit der sich dieses Schirmblech 62 auf den Kühlkörper 16 abstützt. Auf diesem Schirmblech 62 ist die Elektronik-Baugruppe 58 angeordnet, die mit Steueranschlüssen der Halbleitermodule 42, 44, 46, 48 mittels der Bolzen 60 des Verschienungssystems 20 elektrisch leitend verbunden sind. Diese Elektronik-Baugruppe 58 weist für jeden abschaltbaren Halbleiter T₁₁, T₁₂, T₂₁ und T₂₂ eine Ansteuereinrichtung auf. Zusätzlich weist diese Elektronik-Baugruppe 58 Strom- und/oder Spannungswandler, eine Überwachungseinrichtung und eine Signal-Umformereinrichtung auf, die ein optisches Signal in ein elektrisches Signal umformt und umgekehrt. Zur Aufnahme von Lichtwellenleitern weist diese Elektronik-Baugruppe 58 stirnseitig Anschlüsse 66 auf, die aus einer Ausnehmung 68 der Haube 18 der Halbleiter-Baueinheit 10 frontseitig herausragen.

Zur Entwärmung dieser Elektronik-Baugruppe 58 weist die Haube 18 der Halbleiter-Baueinheit 10 Entlüftungsschlitze 70 auf. Eine frontseitige Stirnseite 72 der Haube 18 ist mit einer Ausnehmung 74 versehen, die derart ausgebildet ist, dass diese die frontseitige Wand 50 mit den Anschlüssen X1 und X2 der Stromrichterzelle 2 umschließt. Die rückseitige Stirnseite dieser Haube 18 ist derart ausgestaltet, dass der Teil des L-förmigen Verschienungssystems, der die Anschlüsse 22, 24 und 26 aufweist, seitwärts über die Breite der Haube 18 hinausragt.

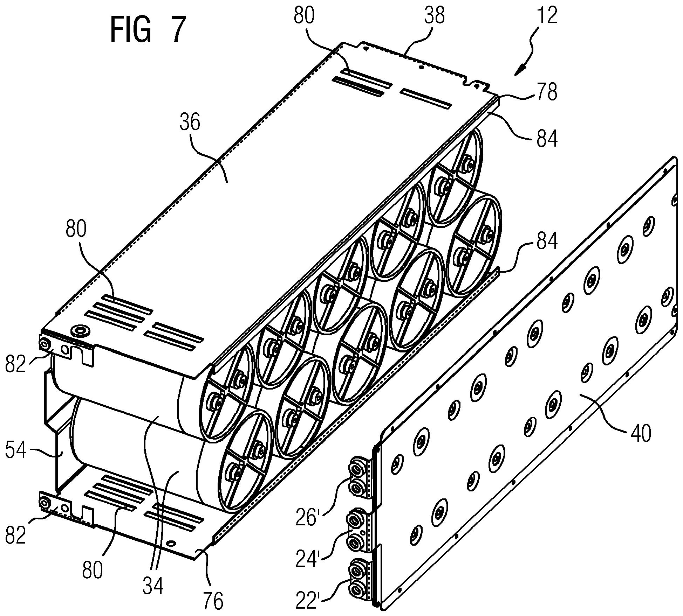

In FIG 7 ist die Kondensator-Baueinheit 12 der Stromrichterzelle 2 nach FIG 5 perspektivisch als Teil-Explosions-Darstellung veranschaulicht. Das heißt, dass das Verschienungssystem 40, das eine Flachseite des Gehäuses 36 der Kondensator-Baueinheit 12 bildet, beabstandet zu dem Teil des Gehäuses 36, das eine Vielzahl von Kondensatoren 34, insbesondere Elektrolytkondensatoren, aufnimmt, dargestellt ist. Dieses Verschienungssystem 40 weist frontseitig drei Anschlüsse 22', 24' und 26' auf, die den Anschlüssen 22,24 und 26 des L-förmigen Verschienungssystems 20 der Halbleiter-Baueinheit 10 entsprechen. Somit weist dieses Verschienungssystem 20 wenigstens drei Stromschienen auf, von denen eine Stromschiene mit dem Anschluss 22' ein negatives Potential N, eine Stromschiene mit dem Anschluss 24' ein Bezugspotential Null und eine Stromschiene mit dem Anschluss 26' ein positives Potential P aufweist. In Abhängigkeit der Anzahl der verwendeten Kondensatoren 34 und deren Verschaltung parallel und/oder in Reihe weist dieses Verschienungssystem 40 noch weitere Stromschienen auf.

Zur Realisierung eines vorbestimmten Kapazitätswerts der Kondensator-Baueinheit 12 wird eine Vielzahl von handelsüblichen Folienkondensatoren 34 benötigt, die beispielsweise in zwei zueinander versetzten Reihen nebeneinander innerhalb des U-förmigen Blechs 38 des Gehäuses 36 der Kondensator-Baueinheit 12 angeordnet und verliersicher mit einem Grundblech 54 des U-förmigen Blechs 38 lösbar verbunden sind. Innerhalb einer Reihe sind diese Folienkondensatoren 34 so ausgerichtet, dass deren elektrische Anschlüsse in einer gedachten Linie liegen. Dadurch vereinfacht sich der Aufbau des Verschienungssystems 40 sehr. Dadurch sind die beiden Reihen von Folienkondensatoren 34 beidseitig von einem Seitenblech 76 bzw. 78 des U-förmigen Blechs 38 flankiert. Diese Seitenbleche 76 und 78 weisen Entlüftungsschlitze 80 auf, die zur Entwärmung dieser Folienkondensatoren 34 partiell oder über die gesamte Länge dieser Seitenbleche 76 und 78 verteilt angeordnet sind. Jedes Seitenblech 76 und 78 weist frontseitig ein Befestigungsblech 82 auf, an dem der Befestigungsflansch 32 der Halbleiter-Baueinheit 10 lösbar befestigt wird. Da das Verschienungssystem 40 mit jedem Kondensator 34 mittels zweier Befestigungsmuttern lösbar befestigt wird, bilden dieses Verschienungssystem 40 und das U-förmige Blech 38 ein verwindungssteifes Gehäuse 36, so dass die Anschlüsse 22', 24' und 26' nicht nur eine elektrische Verbindung mit der Halbleiter-Baueinheit 10 bilden, sondern auch für eine mechanische Verbindung dienen. Zur Aufnahme des Verschienungssystems 40 auf den Seitenwänden 76 und 78 weisen diese jeweils eine Abkantung 84 auf. Das Verschienungssystem 40, das sich auf diesen beiden Abkantungen 84 abstützt, ist ebenfalls mit diesen beiden lösbar befestigt.

Der Kern der Erfindung besteht darin, dass die Bauelemente einer Stromrichterzelle 2 auf zwei Baueinheiten 10 und 12 verteilt sind, die elektrisch und mechanisch miteinander verknüpft sind. Durch die Zweiteilung der Stromrichterzelle 2 teilt sich das Gewicht der Stromrichterzelle 2 auf diese beiden Baueinheiten 10 und 12 auf, so dass jede Baueinheit 10 und 12 ohne zusätzliche Montagehilfen in Aufnahmen eines Traggerüstes für Stromrichterzellen 2 eines modularen Multilevel-Stromrichters gesteckt werden können. Dazu wird die Kondensator-Baueinheit 12 als erste in eine entsprechende Aufnahme des Traggerüstes eingeschoben. Danach wird die Halbleiter-Baueinheit 10 eingeschoben und von vorne mit der Kondensator-Baueinheit 12 elektrisch und mechanisch verknüpft. Da die Halbleiter-Baueinheit 10 frontseitig die Anschlüsse X1 und X2 der Stromrichterzelle 2 aufweist, können eine Vielzahl von derartigen Stromrichterzellen 2 eines modularen Multilevel-Stromrichters frontseitig miteinander verschaltet werden.

Ein weiterer Vorteil besteht darin, dass die Kondensator-Baueinheit 12 jederzeit an einen vorbestimmten Kapazitätswert in Abhängigkeit handelsüblicher Folienkondensatoren 34 angepasst werden kann. Außerdem kann ohne großen Aufwand aus einer Stromrichterzelle 2 in der Ausführungsform eines Doppel-Submoduls 6 gemäß FIG 3 eine Stromrichterzelle 2 in der Ausführungsform eines Single-Submoduls 8 hoher Stromtragfähigkeit gemäß FIG 4 hergestellt werden. Dazu muss lediglich ein angepasstes Verschienungssystem 20 verwendet werden. Somit kann durch die Zweiteilung der Stromrichterzelle 2 eines modularen Multilevel-Stromrichters diese an alle möglichen Kundenwünsche angepasst werden, ohne die Fertigungskosten einer Stromrichterzelle 2 zu erhöhen.

## Patentansprüche

1. Zweiteilige Stromrichterzelle (2) eines modularen Multilevel-Stromrichters als Teile aufweisend
- eine Halbleiter-Baueinheit (10) und
- eine Kondensator-Baueinheit (12),
wobei in einem Gehäuse (14) der Halbleiter-Baueinheit (10) wenigstens zwei abschaltbare Halbleiter (T₁₁,T₁₂,T₂₁,T₂₂) und wenigstens zwei Freilauf-Dioden (D₁₁,D₁₂,D₂₁,D₂₂) thermisch leitend mit einem Kühlkörper (16) verknüpft sind, wobei diese abschaltbaren Halbleiter (T₁₁,T₁₂,T₂₁,T₂₂) und diese Freilauf-Dioden (D₁₁,D₁₂,D₂₁,D₂₂) mittels eines Verschienungssystems (20) elektrisch leitend verbunden sind, dessen Anschlüsse (22,24,26) seitwärts entlang einer Ebene, die durch die rückseitige Stirnseite gebildet wird, aus dem Gehäuse (14) herausragen, wobei in einem weiteren Gehäuse (36) der Kondensator-Baueinheit (12) eine Vielzahl von Kondensatoren (34) mittels eines weiteren Verschienungssystems (40) elektrisch parallel und/oder in Reihe geschaltet sind, wobei das weitere Gehäuse (36) der Kondensator-Baueinheit (12) aus einem U-förmigen Blech (38) und dem weiteren Verschienungssystem (40) besteht, wobei das weitere Verschienungssystem (40) eine Wand des weiteren Gehäuses (36) bildet, wobei Anschlüsse (22',24', 26') des weiteren Verschienungssystems (40) der Kondensator-Baueinheit (12) derart in die frontseitige Stirnseite des weiteren Gehäuses (36) ragen und die Anschlüsse (22,24,26) des Verschienungssystems (20) der Halbleiter-Baueinheit (10) derart rückseitig seitwärts aus dem Gehäuse (14) herausragen, dass sie jeweils elektrisch leitend miteinander verbindbar sind und dass die Halbleiter-Baueinheit (10) und die Kondensator-Baueinheit (12) in einem Traggerüst für Stromrichterzellen (2) eines modularen Multilevel-Stromrichters gesteckt werden können und dass sie in dem Traggerüst für Stromrichterzellen (2) miteinander elektrisch und mechanisch verknüpfbar sind, wobei die Anschlüsse (22,24,26) der Halbleiter-Baueinheit (10) jeweils als eine Lasche ausgebildet sind.

2. Zweiteilige Stromrichterzelle (2) nach Anspruch 1,
**dadurch gekennzeichnet, dass** nach einem Einschieben der Kondensator-Baueinheit (12) in das Traggerüst für Stromrichterzellen (2) und anschließendem Einschieben einer Halbleiter-Baueinheit (14) in das Traggerüst für Stromrichterzellen (2) die Halbleiter-Baueinheit (14) von vorne mit der Kondensator-Baueinheit (12) elektrisch und mechanisch verknüpfbar ist.

3. Zweiteilige Stromrichterzelle (2) nach einem der Ansprüche 1 oder 2, **dadurch gekennzeichnet,**
**dass** der Kühlkörper (16) ein Flüssigkeits-Kühlkörper ist.

4. Zweiteilige Stromrichterzelle (2) nach einem der Ansprüche 1 oder 2, **dadurch gekennzeichnet,**
**dass** der Kühlkörper (16) ein Luft-Kühlkörper ist.

5. Zweiteilige Stromrichterzelle (2) nach einem der Ansprüche 1 oder 2, **dadurch gekennzeichnet,**
**dass** im Gehäuse (14) der Halbleiter-Baueinheit (10) eine Elektronik-Baugruppe (58) der abschaltbaren Halbleiter (T₁₁,T₁₂,T₂₁,T₂₂) angeordnet ist.

6. Zweiteilige Stromrichterzelle (2) nach einem der Ansprüche 1 oder 2, **dadurch gekennzeichnet,**
**dass** das Gehäuse (14) der Halbleiter-Baueinheit (10) aus dem Kühlkörper (16), einem die Anschlüsse (22,24,26) aufweisenden Teil des Verschienungssystems (20) und einer Haube (18) besteht.

7. Zweiteilige Stromrichterzelle (2) nach Anspruch 5, **dadurch gekennzeichnet, dass** die Elektronik-Baugruppe (58) innerhalb des Gehäuses (14) mittels eines Schirmblechs (62) von den abschaltbaren Halbleitern (T₁₁,T₁₂, T₂₁,T₂₂) räumlich getrennt angeordnet ist.

8. Zweiteilige Stromrichterzelle (2) nach einem der Ansprüche 1 bis 7, **dadurch gekennzeichnet,**
**dass** die Kondensatoren (34) der Kondensator-Baueinheit (12) jeweils mit einem Grundblech (58) des U-förmigen Blechs (38) lösbar befestigt sind.

## Claims

1. Bipartite converter cell (2) of a modular multilevel converter as parts comprising
- a semiconductor assembly (10) and
- a capacitor assembly (12),
wherein in a housing (14) of the semiconductor assembly (10) at least two detachable semiconductors (T₁₁, T₁₂, T₂₁, T₂₂) and at least two freewheeling diodes (D₁₁, D₁₂, D₂₁, D₂₂) are linked in a thermally conducting manner to a cooling element (16), wherein these detachable semiconductors (T₁₁, T₁₂, T₂₁, T₂₂) and these freewheeling diodes (D₁₁, D₁₂, D₂₁, D₂₂) are connected in an electrically conducting manner by means of a busbar system (20), the terminals (22, 24, 26) of which project laterally out of the housing (14) along a plane which is formed by the rear end face, wherein in a further housing (36) of the capacitor assembly (12), a plurality of capacitors (34) are connected electrically in parallel and/or in series by means of a further busbar system (40), wherein the further housing (36) of the capacitor assembly (12) consists of a U-shaped sheet (38) and the further busbar system (40), wherein the further busbar system (40) forms a wall of the further housing (36), wherein terminals (22', 24', 26') of the further busbar system (40) of the capacitor assembly (12) project into the front end face of the further housing (36) and the terminals (22, 24, 26) of the busbar system (20) of the semiconductor assembly (10) project rearward laterally out of the housing (14) in such a way that they can be connected in an electrically conducting manner with one another in each case and that the semiconductor assembly (10) and the capacitor assembly (12) can be plugged into a supporting frame for converter cells (2) of a modular multilevel converter and that they can be linked electrically and mechanically to one another in the supporting frame for converter cells (2), wherein the terminals (22, 24, 26) of the semiconductor assembly (10) are each embodied as a lug.

2. Bipartite converter cell (2) according to claim 1, **characterised in that** after inserting the capacitor assembly (12) into the supporting frame for converter cells (2) and then inserting a semiconductor assembly (14) into the supporting frame for converter cells (2), the semiconductor assembly (14) can be linked electrically and mechanically with the capacitor assembly (12) from the front.

3. Bipartite converter cell (2) according to one of claims 1 or 2, **characterised in that** the cooling element (16) is a liquid cooling element.

4. Bipartite converter cell (2) according to one of claims 1 or 2, **characterised in that** the cooling element (16) is a pneumatic cooling element.

5. Bipartite converter cell (2) according to one of claims 1 or 2, **characterised in that** an electronic module (58) of the detachable semiconductors (T₁₁, T₁₂, T₂₁, T₂₂) is arranged in the housing (14) of the semiconductor assembly (10).

6. Bipartite converter cell (2) according to one of claims 1 or 2, **characterised in that** the housing (14) of the semiconductor assembly (10) consists of the cooling element (16), a part of the busbar system (20) having the terminals (22, 24, 26) and a hood (18).

7. Bipartite converter cell (2) according to claim 5, **characterised in that** the electronic module (58) within the housing (14) is arranged spatially separated from the detachable semiconductors (T₁₁, T₁₂, T₂₁, T₂₂) by means of a screening shield (62).

8. Bipartite converter cell (2) according to one of claims 1 to 7, **characterised in that** the capacitors (34) of the capacitor assembly (12) are each detachably fastened to a base sheet (58) of the U-shaped sheet (38).

## Revendications

1. Cellule (2) de convertisseur en deux parties d'un convertisseur modulaire à plusieurs niveaux comme parties, comportant
- une unité (10) de construction à semi-conducteur et
- une unité (12) de construction à condensateur,
dans lequel, dans un boîtier (14) de l'unité (12) de construction à semi-conducteur, au moins deux semi-conducteurs (T₁₁, T₁₂, T₂₁, T₂₂) pouvant être bloqués et au moins deux diodes (D₁₁, D₁₂, D₂₁, D₂₂) de roue libre sont reliés d'une manière conductrice thermiquement à un refroidisseur (16), ces semi-conducteurs (T₁₁, T₁₂, T₂₁, T₂₂) pouvant être bloqués et ces diodes (D₁₁, D₁₂, D₂₁, D₂₂) de roue libre étant connectés d'une manière conductrice de l'électricité au moyen d'un système (20) de connexion, dont les bornes (22, 24, 26) sortent du boîtier (14) latéralement suivant un plan formé par le côté frontal du côté arrière, dans laquelle, dans un autre boîtier (36) de l'unité (12) à condensateur, une pluralité de condensateurs (34) sont montés en parallèle et/ou en série électriquement au moyen d'un autre système (40) de connexion, l'autre boîtier (36) de l'unité (12) de construction à condensateur étant constitué d'une tôle (38) en forme de U et de l'autre système (40) de connexion, l'autre système (40) de connexion formant une paroi de l'autre boîtier (36), des bornes (22', 24', 26') de l'autre système (40) de connexion de l'unité (12) de construction à condensateur pénétrant dans le côté frontal du côté avant de l'autre boîtier (36) et les bornes (22, 24, 26) du système (20) de connexion de l'unité (10) de construction à semi-conducteur sortant du boîtier (14) latéralement du côté arrière, de manière à pouvoir être connectées entre elles d'une manière conductrice de l'électricité et en ce que l'unité (10) de construction à semi-conducteur et l'unité (12) de construction à condensateur peuvent être enfichées dans une ossature porteuse pour des cellules (2) de convertisseur d'un convertisseur modulaire à plusieurs niveaux et en ce qu'elles peuvent être reliées entre elles électriquement et mécaniquement dans l'ossature porteuse pour des cellules (2) de convertisseur, les bornes (22, 24, 26) de l'unité (10) de construction à semi-conducteur étant constituées chacune sous la forme d'une languette.

2. Cellule (2) de convertisseur en deux parties suivant la revendication 1, **caractérisée**
**en ce qu'**après avoir enfilé l'unité (12) de construction à condensateur dans l'ossature porteuse pour des cellules (2) de convertisseur et après avoir ensuite enfilé l'unité (14) de construction à semi-conducteur dans l'ossature porteuse pour des cellules (2) de convertisseur, l'unité (14) de construction à semi-conducteur peut être reliée électriquement et mécaniquement par l'avant à l'unité (12) de construction à condensateur.

3. Cellule (2) de convertisseur en deux parties suivant l'une des revendications 1 ou 2, **caractérisée**
**en ce que** le refroidisseur (16) est un refroidisseur à liquide.

4. Cellule (2) de convertisseur en deux parties suivant l'une des revendications précédentes, **caractérisée**
**en ce que** le refroidisseur (16) est un refroidisseur à air.

5. Cellule (2) de convertisseur en deux parties suivant l'une des revendications 1 ou 2, **caractérisée**
**en ce que**, dans le boîtier (14) de l'unité (10) de construction à semi-conducteur, est disposé un module (58) électronique des semi-conducteurs (T₁₁, T₁₂, T₂₁, T₂₂) pouvant être bloqués.

6. Cellule (2) de convertisseur en deux parties suivant l'une des revendications 1 ou 2, **caractérisée**
**en ce que** le boîtier (14) de l'unité (10) de construction à semi-conducteur est constitué du refroidisseur (16), d'une partie ayant les bornes (22, 24, 26) du système (20) de connexion et d'un capot (18).

7. Cellule (2) de convertisseur en deux parties suivant la revendication 5, **caractérisée**
**en ce que** le module (58) électronique est disposé à l'intérieur du boîtier (14) en étant séparé dans l'espace des semi-conducteurs (T₁₁, T₁₂, T₂₁, T₂₂) pouvant être bloqués au moyen d'une tôle (62) de blindage.

8. Cellule (2) de convertisseur en deux parties suivant l'une des revendications 1 à 7, **caractérisée**
**en ce que** les condensateurs (34) de l'unité (12) de construction à condensateur sont fixés de manière amovible chacun par une tôle (58) de base de la tôle (38) en forme de U.
